# EUROPEAN PATENT APPLICATION

(11) **EP 4 815 714 A1**
(43) Date of publication of application: **30.09.2026**
(21) Application number: 26167246.3
(22) Date of filing: 24.03.2026
(51) Int. Cl.: H10W 74/01, H10W 72/00

(54) **METHOD OF SEMICONDUCTOR MANUFACTURING, CORRESPONDING SEMICONDUCTOR PRODUCT AND DEVICE**

(30) Priority: 27.03.2025 IT 202500006438
(71) Applicant: STMicroelectronics International N.V., 1228 Plan-les-Ouates, Geneva (CH)
(72) Inventor: VITELLO, Dario, I-23807 Merate (Lecco) (IT); BELLIZZI, Antonio, I-20093 Cologno Monzese (Milano) (IT)
(74) Representative: Buzzi, Notaro & Antonielli d'Oulx S.p.A.

(57) **Abstract**

A plurality of semiconductor dice (14) is encapsulated in an electrically insulating encapsulation (20, 21) to form a panel (100) having the plurality of semiconductor dice (14) embedded therein.

Trenches (T) are formed in a surface of the panel (100) having the plurality of semiconductor dice (14) embedded therein, wherein the trenches (T) are formed at singulation lines (SL) between adjacent panel portions, each panel portion comprising at least one semiconductor die (14) of said plurality of semiconductor dice (14).

A patterned metallic layer (160, 12, CB) is formed at the surface of the panel (100) by growing electrically conductive material at selected regions thereof.

The patterned metallic layer (160, 12, CB) comprises:
a redistribution layer (160) common to the plurality of semiconductor dice (14) embedded in the panel (100),
pads (12) grown onto the common redistribution layer (160), wherein the pads (12) are electrically coupled to semiconductor dice (14) in the plurality of semiconductor dice (14) embedded in the panel (100) via the common redistribution layer (160), and
connecting bars (CB) grown at said trenches (T) formed in the surface of the panel (100), wherein the connecting bars (CB) are electrically coupled to the pads (12) via the common redistribution layer (160).

## Description

### Technical field

The description relates to semiconductor devices.

One or more embodiments can be applied to manufacturing processes of (integrated circuit, IC) semiconductor devices processed via panel level processing.

### Background

Semiconductor devices may be configured to be mounted on a supporting substrate (a printed circuit board, PCB, for instance) via soldering, for instance.

To that effect, final processing steps in conventional manufacturing processes of semiconductor devices comprise providing solderable material at the outer pads (that is, the pads configured to be soldered on the PCB) to facilitate mounting on the final substrate.

In leadframe based semiconductor devices, for instance, solderable material (tin, for instance) may be grown via an electrolytic plating bath where an electric field between an anode and the pads to be plated (acting as a cathode) forces positively charged metal ions to move to the cathode where they give up their charge and deposit themselves as metal on the surface of the pads.

In manufacturing processes such as so-called panel level packaging (PLP), the plating step is performed via an electroless plating bath, since an electric field cannot be established between the anode and the pads of the devices.

However, electroless plating of tin material results in the formation of an undesirably thin layer of tin at the pads, which gives unsatisfactory results in terms of solderability.

Electroless-Nickel Immersion-Gold, ENIG, an electroless plating process, gives satisfactory results. However, plating gold increases significantly the cost of the package.

JP 2004140037 A discloses a semiconductor device comprising a plurality of stacked semiconductor chips, first wiring for electrically connecting the integrated circuits of the plurality of semiconductor chips, an outer terminal for sealing the plurality of semiconductor chips and the first wiring. A multichip semiconductor device is provided in which the mounting area is reduced.

US 2022/230983 A1 discloses a semiconductor device including an insulation layer, wires, a semiconductor element, and an encapsulation resin. The insulation layer includes a main surface and a back surface facing opposite in a thickness-wise direction and a side surface formed between the main surface and the back surface in the thickness-wise direction. The wires include an embedded portion embedded in the insulation layer and a redistribution portion formed of a metal film joined to the embedded portion and formed from the back surface to the side surface. The semiconductor element is mounted on the main surface and includes electrodes joined to at least part of the embedded portion of the wires. The encapsulation resin contacts the main surface and covers the semiconductor element.

Documents such as US 20230317663 A1, US 20190122967 A1, US 20230114872 A1, US 20200350180 A1 and US 20180068920 A1 provide background information in the related technological area.

### Object and summary

An object of one or more embodiments is to overcome the drawbacks discussed in the foregoing.

According to one or more embodiments, that object is achieved via a method having the features set forth in the claims that follow.

One or more embodiments also relate to a corresponding (intermediate) semiconductor product and a corresponding semiconductor device.

The claims are an integral part of the technical teaching provided in respect of the embodiments.

Solutions as described herein may be applied to panel level processing in manufacturing processes of semiconductor devices.

Solutions as described herein involve forming trenches in a surface of a panel.

Solutions as described herein comprise forming connecting bars at the trenches formed in the surface of the panel to facilitate further processing steps.

Solutions as described herein involve electroplating solder material to form layers of solder material at pads configured to be soldered on a final supporting substrate.

In solutions as described herein, a side surface of the pads of solder material is exposed at the side surface of the semiconductor device thus providing wettable flanks for the semiconductor device.

### Brief description of the figures

One or more embodiments will now be described, by way of example only, with reference to the annexed figures, wherein:
Figures 1A to 1O are cross-sectional views illustrative of a sequence of processing steps according to embodiments of the present description, and
Figures 2A to 12A are plan views illustrative of details of a semiconductor product resulting from selected processing steps of the sequence illustrated in Figures 1A to 1O,
Figures 2B to 12B are cross-sectional views along first lines of the corresponding plan views of Figures 2A to 12A,
Figures 2C to 12C are cross-sectional views along second lines of the corresponding plan views of Figures 2A to 12A, and
Figure 13 is a cross-sectional view of a semiconductor device obtainable via processing steps according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

As mentioned, semiconductor devices may be configured to be mounted on a final supporting substrate such as a printed circuit board, PCB, for instance.

Attaching a semiconductor device to such a substrate may be done via soldering, for instance, in order to facilitate forming electrical coupling between the semiconductor device and the PCB.

To that effect, solder material is provided at the pads configured to be soldered to the substrate.

In leadframe based semiconductor devices, solder material (tin or a tin alloy, for instance) may be provided by electrolytic (or galvanic) plating; a layer of solder material may be formed at the pads via electrolytic plating, facilitated by an electric field establishes between an anode and the pads to be plated (acting as a cathode) that forces positively charged metal ions to move to the cathode where they give up their charge and deposit themselves as metal at the surface of the pads.

In manufacturing processes such as in so-called panel level packaging (PLP), pads are formed by selectively growing electrically conductive material at a surface of a panel. Pads formed in this way are not electrically coupled between each other (and to an outer frame, for instance, as it is the case in leadframe based devices) making difficult to establish an electric field for electrolytic plating.

An electroless plating is used for plating solder material at the surface of the pads.

However, only a relatively thin (for instance, about 3 microns) layer of solder material (such as tin, for instance) may be grown via electroless plating, which gives unsatisfactory results in terms of solderability.

Electroless-Nickel Immersion-Gold, ENIG, an electroless plating process, is thus used, which gives satisfactory results. However, plating gold increases significantly the cost of the package.

Solutions as described herein may be applied to panel level processing in manufacturing processes of semiconductor devices.

Solutions as described herein involve forming trenches in a surface of a panel.

Solutions as described herein comprise forming connecting bars at the trenches formed in the surface of the panel to facilitate further processing steps.

Solutions as described herein involve electroplating solder material to form layer of solder material at pads configured to be soldered on a final supporting substrate.

In solutions as described herein, a side surface of the pads of solder material is exposed at the side surface of the semiconductor device thus providing wettable flanks for the semiconductor device.

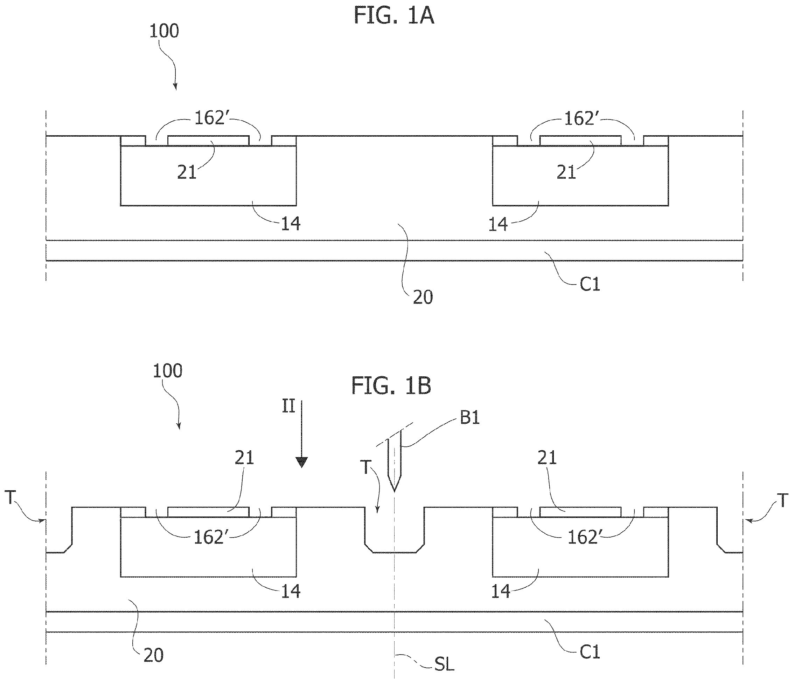

Figures 1A to 1O are cross-sectional views illustrative of a sequence of processing steps according to embodiments of the present description.

It will be appreciated that the sequence of steps of Figures 1A to 1O is merely exemplary insofar as:
one or more steps illustrated in Figures 1A to 1O can be omitted, performed in a different manner (with other tools, for instance) and/or replaced by other steps;
additional steps may be added;
one or more steps can be carried out in a sequence different from the sequence illustrated.

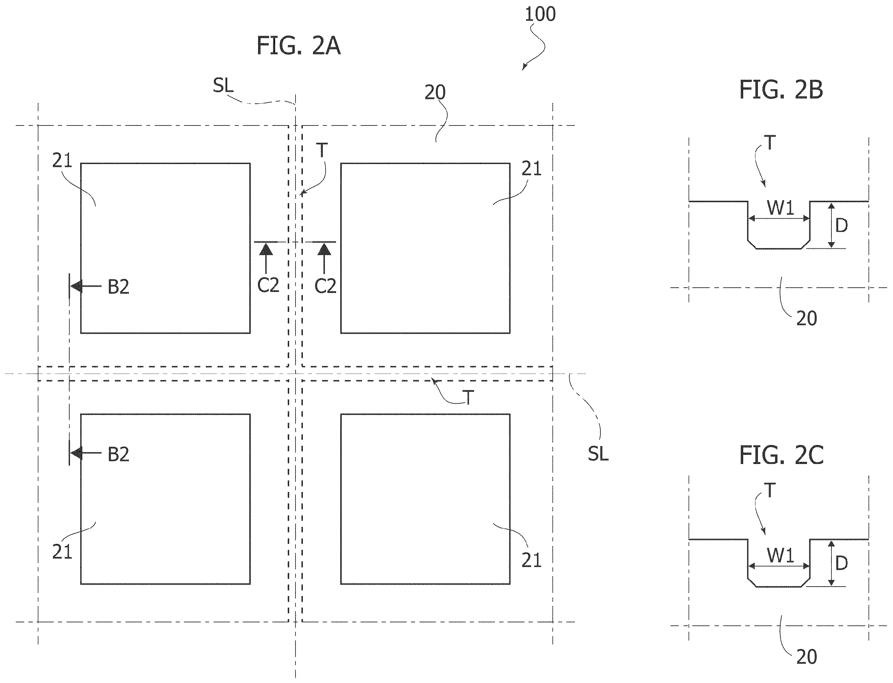

In describing the sequence of processing steps illustrated in Figures 1A to 1O, reference is also made to Figures 2A to 12A, 2B to 12B and 2C to 12C.

Figures 2A to 12A are plan views illustrative of details of a panel resulting from selected ones of the processing steps in the sequence illustrated in Figures 1A to 1O.

Figures 2B to 12B are cross-sectional views along first lines of the corresponding plan views of Figures 2A to 12A (wherein the first lines are indicated with the reference Bn-Bn in each plan view illustrated in Figure nA), and

Figures 2C to 12C are cross-sectional views along second lines of the corresponding plan views of Figures 2A to 12A (wherein the second lines are indicated with the reference Cn-Cn in each plan view illustrated in Figure nA).

Figure 1A is illustrative of a wafer or panel 100 arranged on a first temporary (and possibly sacrificial) carrier C1.

The panel or wafer 100 comprises a plurality of semiconductor dice or chips 14 (the terms chip/chips and die/dice are herein regarded as synonymous) embedded in an electrically insulating encapsulation 20, 21.

Hereinafter, reference will be made to a panel 100 being otherwise understood that a sequence of processing steps as described in relation to Figures 1A to 1O may be applied to both wafer level and/or panel level processing, irrespective of the particular shape and/or size of the wafer or panel.

Providing a panel 100 as illustrate in Figure 1A may involve:
providing a semiconductor (Si, SiC, GaN, for instance) wafer having embedded therein (in any way known in the art) a plurality of integrated circuits, ICs, (not visible in the figures for simplicity),
laminating an electrically insulating build-up film 21 (also referred to as mold film), such as an Ajinomoto Build-Up Film, for instance, at a surface of the semiconductor wafer (the active surface),
opening vias 162' (by applying laser beam energy, for instance) towards the semiconductor dice 14 through the build-up film 21 to uncover corresponding die bonding pads (that is, electrical contacts, not visible in the figures for scale reasons) at the active surface of the semiconductor dice 14,
singulating the semiconductor wafer into a plurality of individual (singulated) semiconductor dice 14, each semiconductor die 14 comprising at least one integrated circuit and a portion of the build-up film 21 laminated at the active surface thereof,
arranging the plurality of individual (singulated) semiconductor dice 14 on a temporary carrier, and
molding an electrically insulating molding material 20 (an epoxy resin, for instance) onto the plurality of individual semiconductor dice 14 arranged on the temporary carrier.

As illustrated in Figure 1A, each semiconductor die 14 has a portion of the build-up film 21 (laminated prior to the singulation step) provided at the active surface of the semiconductor die 14, with vias 162' opened through the build-up film 21 towards the die bonding pads of the semiconductor die 14.

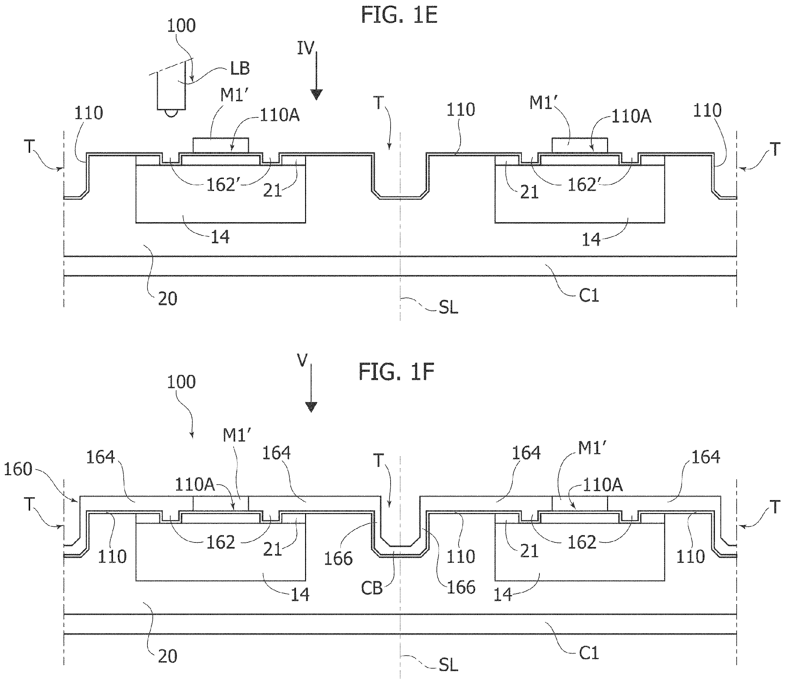

The reference 162' with an accent "‴ is used to highlight the fact that proper, electrically conductive, vias (indicated with the reference 162 in Figure 1F, for instance) will be formed in a subsequent processing step.

As illustrated in Figure 1A, the portion of the (electrically insulating) build-up film 21 and the (electrically insulating) molding material 20 provide an electrically insulating encapsulation for the plurality of (IC) semiconductor dice 14.

Said otherwise, Figure 1A is illustrative of a panel 100 of electrically insulating material 20, 21 encapsulating a plurality of semiconductor dice 14, the panel 100 having the plurality of semiconductor dice 14 embedded therein.

Providing a panel 100 as exemplified in Figure 1A is otherwise conventional in the art, which makes it unnecessary to provide a more detailed description herein.

Figure 1B is illustrative of a processing step where trenches T are formed in a surface (the top surface in the figures) of the panel 100, by removing electrically insulating material (for instance, the molding material 20) therefrom.

According to embodiments of the present description, trenches T are formed at singulation lines SL located between semiconductor dice 14. In fact, as discussed in the following, in a (final) singulation step, the panel 100 is partitioned or singulated with cuts (via sawing, for instance) at the singulation lines SL. A plurality of panel portions (wherein each panel portion provides a final, individual, device) is obtained in response to the (final) singulation step.

Trenches T formed in the top surface of the panel 100 are visible also in Figures 2A to 2C.

Figure 2A is a plan view of a panel 100 as illustrated in Figure 1B seen in the direction of view indicated by the arrow II of Figure 1B.

More in detail, Figure 2A is illustrative of a portion of a panel 100 comprising four semiconductor dice 14 embedded therein (that is, embedded in the electrically insulating encapsulation material 20); the portion of build-up film 21 is visible at the surface of the panel 100.

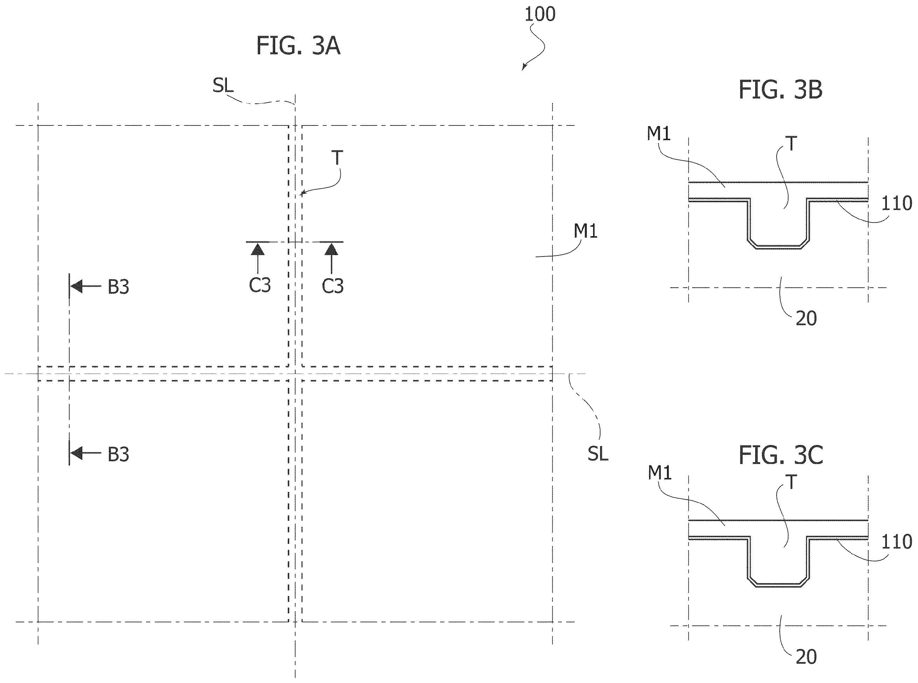

It is noted that vias 162' are not visible in Figure 2A (and following Figures 3A to 12A) for simplicity.

As illustrated, trenches are formed at singulation lines SL between adjacent panel portions.

In embodiments as exemplified in the figures, each panel portion comprises one semiconductor die 14.

In one or more embodiments, the panel 100 may be singulated (in a final singulation step) into panel portions that comprise two or more semiconductor dice. Also in these embodiments, trenches T may be formed at singulation lines SL at which the panel 100 is singulated.

That is, trenches T may be formed at singulation lines SL between adjacent panel portions, wherein each panel portion comprises at least one semiconductor die 14 of the plurality of semiconductor dice 14 embedded in the panel 100.

Figures 2B and 2C are cross-sectional views along lines B2-B2 and C2-C2, respectively, illustrative of trenches T formed at the singulation lines SL.

With reference to Figures 2B and 2C, trenches T may be formed with a trench width W1 of about 400 microns, for instance, and a trench depth D in a range of value between 20% and 80% of the thickness of the panel 100.

Trenches T may be formed via laser ablation, for instance.

Advantageously, trenches T may be formed by partially cutting the panel 100 via a first blade B 1, starting from the top surface thereof; as mentioned previously, trenches T with a trench depth D in the range of values between 20% and 80% of the thickness of the panel 100 may be formed.

The first blade B1 may have a first width that is (at least notionally) equal to the trench width W1 (400 microns, for instance).

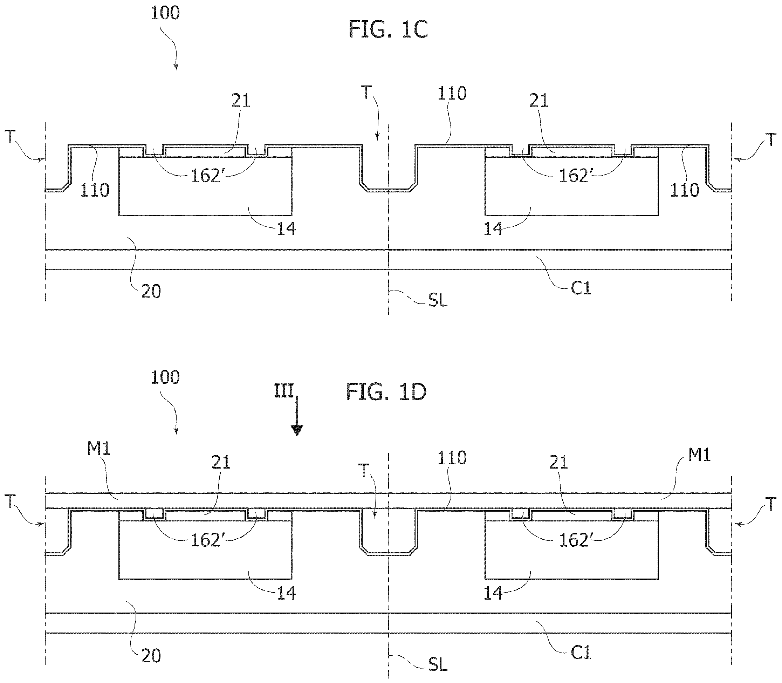

Figures 1C to 1J are illustrative of processing steps according to embodiments of the present description to form a patterned metallic layer at the top/front surface of the panel 100.

As described in the following, the patterned metallic layer comprises:
a redistribution layer common for the plurality of semiconductor dice 14 embedded in the panel 100 (that is, embedded in the electrically insulating encapsulation 20, 21),
pads grown onto the common redistribution layer and configured to provide I/O contacts to the (finished) device, and
connecting bars grown at the trenches T formed in the top/front surface of the panel 100.

As known to those skilled in the art, a redistribution layer comprises a pattern of electrically conductive traces and vias that provides input/output (I/O) pads of an integrated circuit (that is, the die bonding pads provided at the active surface of the semiconductor dice 14) available in other locations.

The patterned metallic layer may be formed by growing electrically conductive material (copper, for instance) at selected locations of the top/front surface of the panel 100, as discussed in the following.

Figure 1C is illustrative of a seed layer 110 formed at the top surface (again, the top surface in the figures) of the panel 100, that is, at the top surface of the electrically insulating encapsulation 20, 21.

The seed layer 110 may be formed via sputtering, for instance, of metallic material such as Ti and/or Cu material.

As illustrated in Figure 1C, a seed layer 110 is formed over the whole top surface of the panel 100. The seed layer 110 is formed at the vias 162' opened in the electrically insulating encapsulation 21 in order to facilitate growing electrically conductive material (copper, for instance) to form proper, electrically conductive, vias to the semiconductor dice 14.

As illustrated, the seed layer 110 is also formed at the trenches T formed in the top surface of the panel 100, onto the bottom surfaces of the trenches as well as onto the side surfaces of the trenches T.

Figure 1D is illustrative of a first layer M1 of photoresist material provided at the surface of the panel 100. The first photoresist layer M1 may be provided as a dry film of photoresist material laminated at the (top) surface of the panel 100, for instance.

As illustrated in Figure 1E, the first photoresist layer M1 is patterned according to a desired pattern. Transferring a pattern to the first photoresist layer M1 may involve applying laser beam energy LB at selected portions of the first photoresist layer M1 provided at the surface of the panel 100 and, subsequently, developing the first photoresist layer M1 to obtain a first patterned photoresist layer M1' (as illustrated in Figure 1E).

In one or more embodiments, laser direct imaging (LDI) techniques may be used to transfer a desired pattern to the first photoresist layer M1.

As illustrated, the first patterned photoresist layer M1' leaves uncovered selected portions of the top/front surface of the panel 100 (that is, the top/front surface of the electrically insulating encapsulation 20, 21) having the seed layer 110 formed thereon.

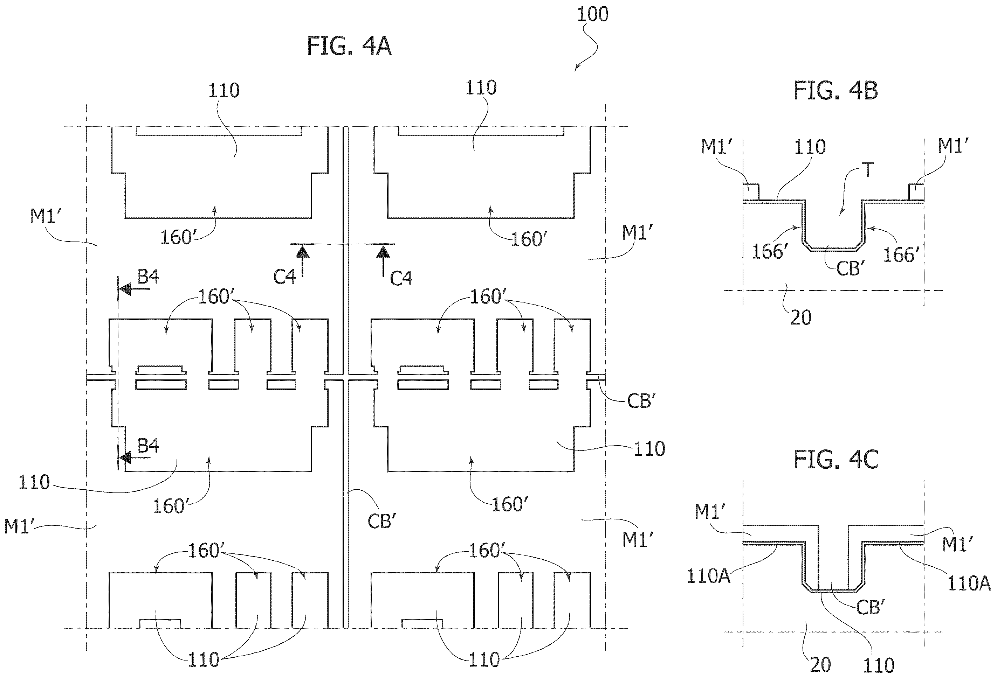

The processing steps of providing and patterning the first photoresist layer M1, M1' are illustrated also in Figures 3A to 3C and 4A to 4C, wherein:

Figures 3A is a plan view of a panel 100 as illustrated in Figures 1D seen in the direction of view indicated by the arrow III of Figure 1D,

Figures 3B and 3C are cross-sectional views along lines B3-B3 and C3-C3, respectively, of Figure 3A,

Figures 4A is a plan view of a panel 100 as illustrated in Figures 1E seen in the direction of view indicated by the arrow IV of Figure 1E, and

Figures 4B and 4C are cross-sectional views along lines B4-B4 and C4-C4, respectively, of Figure 4A.

With reference to Figures 3A and 4A, a first photoresist layer M1 is provided over the whole (top or front) surface of the panel 100 (onto the seed layer 110 formed previously) and, subsequently, patterned (via LDI techniques, for instance) to provide the first patterned photoresist layer M1'. The first patterned photoresist layer M1' has apertures at selected regions of the top/front surface of the panel 100 (that is, the top/front surface of the electrically insulating encapsulation 20) that leave uncovered the seed layer 110 formed thereon; these locations are indicated with the references 160', CB' in Figure 4A.

As illustrated in Figures 3B and 3C, the first photoresist layer M1 is provided also at the trenches T (with photoresist material filling the trenches T, for instance), covering the seed layer 110 formed at the trenches T (at the bottom surface as well as at the side surfaces thereof).

With reference to Figures 4B and 4C, the first patterned photoresist layer M1' may have apertures that leave uncovered:
the seed layer 110 at a bottom surface of the trenches T, that is, the regions indicated with the reference CB' in Figures 4B and 4C, and
the seed layer 110 at side surfaces of the trenches T, that is, the regions indicated with the reference 166' in Figure 4B.

Referring again to Figure 4A, the seed layer 110 is exposed (that is, left uncovered by the first patterned photoresist layer M1') at selected regions of the top/front surface of the panel 100 or, said otherwise, apertures are opened in the first photoresist layer according to an aperture pattern. As illustrated, the aperture pattern may comprise:
a redistribution pattern 160' comprising the vias 162', traces and, optionally, regions 166' at the side surfaces of the trenches T, and
a connection pattern CB'.

As discussed in the following, according to the present description, electrically conductive material (copper, for instance) is grown at the redistribution pattern 160' and at the connection pattern CB' to form, respectively, the common redistribution layer and the connecting bars CB of the patterned metallic layer.

Again, references 160', 166' and CB' with an accent "‴ are used to highlight the fact that proper, electrically conductive formations will be formed in a subsequent processing step. Such electrically conductive formations may be formed by growing, via electrolytic (or galvanic) plating, electrically conductive material onto the selected locations of the seed layer 110 left uncovered by the first patterned photoresist layer M1'.

In an electrolytic plating bath (also referred to as electroplating bath), an electric field between an anode and a workpiece, acting as a cathode, forces positively charged metal ions (of copper, for instance) to move to the cathode where they give up their charge and deposit as metal on the surface of the workpiece.

The seed layer 110, which covers the whole front/top surface of the panel 100, acts as a cathode in the electrolytic plating step, thus facilitating growing metallic material at the selected portions of the seed layer 110 left uncovered by the patterned first photoresist layer M1'.

As illustrated in Figure 1E, for instance, regions 110A of the seed layer 110 are covered by the first patterned photoresist layer M1' that counters growth of electrically conductive material at these regions 110A.

Figure 1F is illustrative of electrically conductive material (copper, for instance) grown at the top/front surface of the panel 100, at the redistribution pattern 160'
and at the connection pattern CB' to form an electrically conductive common redistribution layer 160 and electrically conductive connecting bars CB.

As illustrated, the common redistribution layer 160 comprises:
electrically conductive vias 162 extending through the electrically insulating encapsulation 21 (a build-up film), from the top/front surface of the panel 100 to the semiconductor dice 14, and
electrically conductive traces/lines 164 extending at the front/top surface of the panel 100 starting from the vias 162 and electrically coupled thereto.

As illustrated, electrically conductive material is grown also at the trenches T to form therein connecting bars CB electrically coupled to the common redistribution layer 160. The common redistribution layer 160 may comprise electrically conductive lines/traces 166 grown at the side surfaces of the trenches T electrically coupled to the connecting bars CB (formed at the bottom surface of the trenches T).

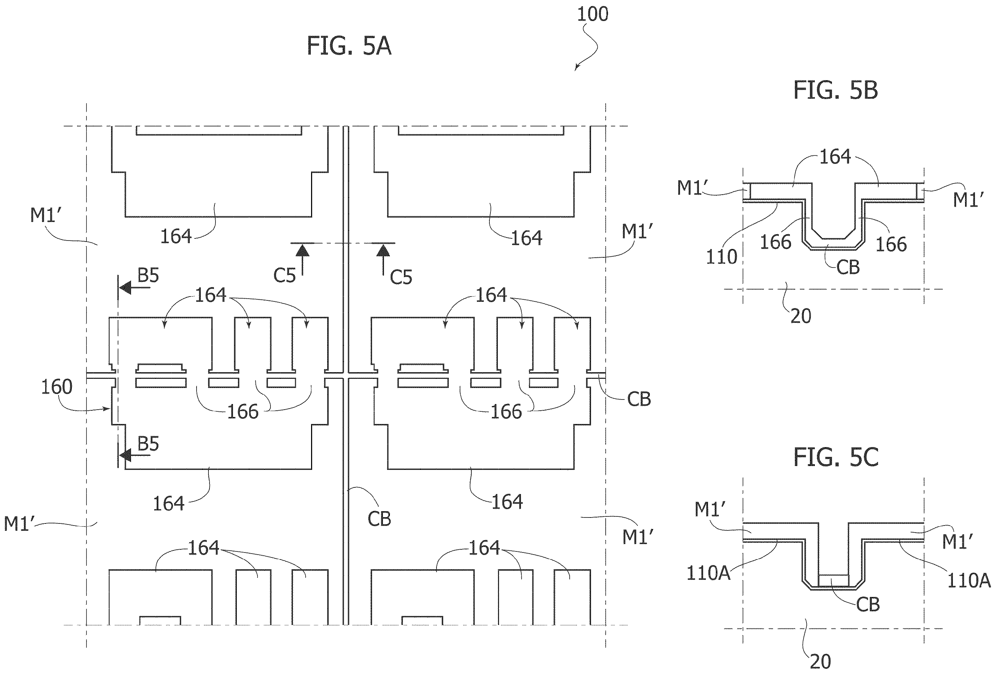

The result of a processing step as described in the foregoing is illustrated also in Figures 5A to 5C, wherein:

Figures 5A is a plan view of a panel 100 as illustrated in Figure 1F seen in the direction of view indicated by the arrow V of Figure 1F,

Figures 5B and 5C are cross-sectional views along lines B5-B5 and C5-C5, respectively, of Figure 5A.

As illustrated in the plan view of Figure 5A a (first) electrolytic plating step as described in the foregoing results in the formation of:
a redistribution layer 160 common to the plurality of semiconductor dice 14 embedded in the electrically insulating molding material 20 of the panel 100, and
connecting bars CB grown at the trenches T formed in the surface of the panel 100, electrically coupled to the common redistribution layer 160.

With reference to Figures 5B and 5C, electrically conductive material may be grown at:
the bottom surface of the trenches T to form the electrically conductive connecting bars CB, as illustrated in Figures 5B and 5C, and
the side surfaces of the trenches T, to form electrically conductive lines 166 electrically coupling the traces 164 (extending at the top/front surface of the panel 100) to the connecting bars CB formed at the bottom surface of the trenches T, as illustrated in Figure 5B.

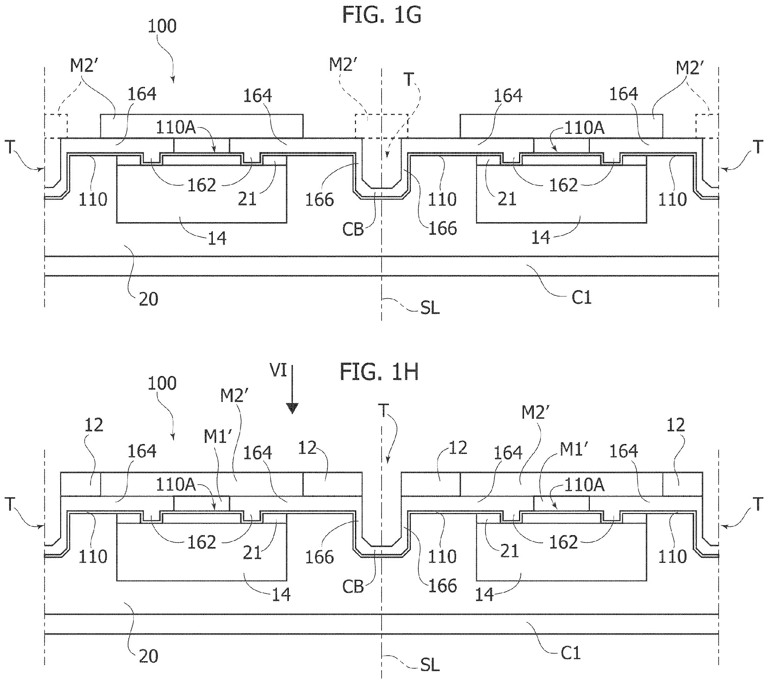

Figures 1G to 1H are cross-sectional views illustrative of processing steps to form electrically conductive pads 12 (I/O pads, for instance) onto the redistribution layer 160 by growing electrically conductive material (copper, for instance) onto selected regions thereof.

Similarly to what has been described with reference to Figures 1D to 1F, growing electrically conductive pads 12 may involve:
providing a second layer of photoresist material, by laminating a second dry film of photoresist material, for instance, and
patterning the second photoresist layer according to a desired pattern for the pads 12.

Laser direct imaging, LDI, techniques may be used to transfer a desired pattern to the second photoresist layer.

Figure 1G is illustrative of the second patterned photoresist layer M2' provided onto the common redistribution layer 160.

As illustrated, the second patterned photoresist layer M2' may be provided on the first patterned photoresist layer M1' (kept at the top/front surface of the panel 100).

The second patterned photoresist layer M2' has apertures that leave exposed electrically conductive material of the common redistribution layer 160 (that is, left uncovered by the second patterned photoresist layer M2').

Optionally, the second patterned photoresist layer M2' may have apertures at selected regions of the trenches T. This fact is illustrated in Figure 1G, where portions of the second patterned photoresist layer M2' at the trenches T are illustrated with dashed lines, to highlight the fact that such portions are optional. Forming apertures also at the trenches cause further electrically conductive material to grow at the trenches T, that is, onto the electrically conductive material of the lines 166 grown at the side surfaces of the trenches T and onto the electrically conductive material of the connecting bars CB grown at the bottom surface of the trenches T.

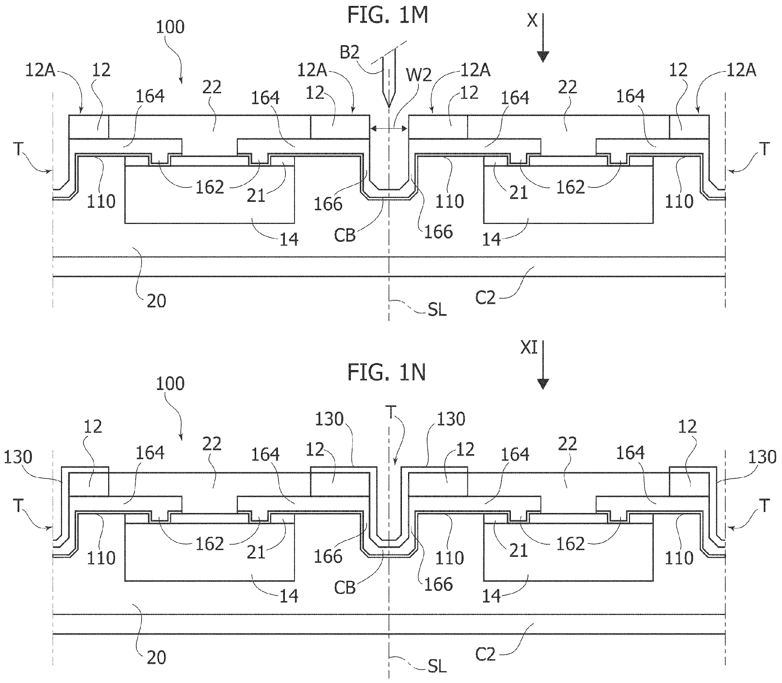

Growing further electrically conductive material at such regions of the trenches T may be advantageous in so far as a portion of the electrically conductive material grown thereon may be removed in a subsequent processing step (such as the processing step described later with reference to Figure 1M).

Figure 1H is illustrative of electrically conductive material grown at the apertures in the second patterned photoresist layer M2' to form electrically conductive pads (or studs) 12 onto the common redistribution layer 160.

Electrically conductive material (metallic material such as copper, for instance) may be grown via an electrolytic plating (electroplating) bath, for instance, similar to the plating bath used to form the common redistribution layer 160 and the connecting bars CB. The common redistribution layer 160 (kept at a desired plating potential via the seed layer 110) acts as a cathode in the (second) electrolytic plating step, thus facilitating growing metallic material at the selected regions of the common redistribution layer 160 left uncovered by the second patterned photoresist layer M2'.

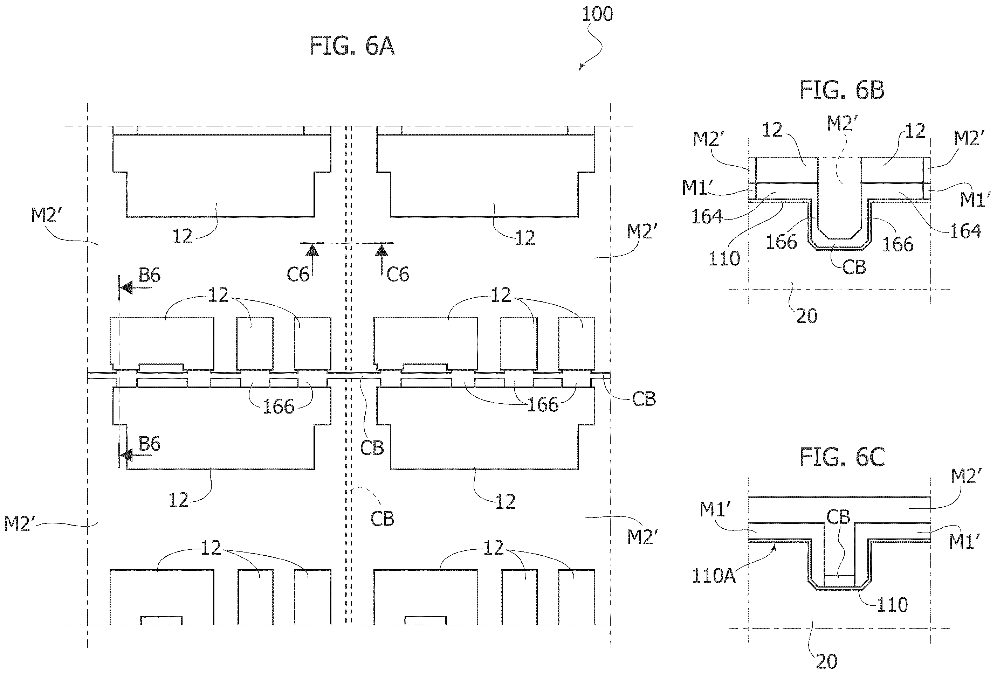

The result of such a processing step is also illustrated in Figures 6A to 6C, wherein:

Figures 6A is a plan view of a panel 100 as illustrated in Figures 1H seen in the direction of view indicated by the arrow VI of Figure 1H,

Figures 6B and 6C are cross-sectional views along lines B6-B6 and C6-C6, respectively, of Figure 6A.

As illustrated in Figure 1H, 6A and 6B, the second patterned photoresist layer M2' may have apertures also at the trenches T in order to grow further electrically conductive material therein. As illustrated, the second patterned photoresist layer M2' may advantageously have apertures at regions of the trenches T where electrically conductive lines/traces 166 are (already) formed.

More in details, the second patterned photoresist layer M2' may cover the connecting bars CB at portions thereof where it is not desired to grow further electrically conductive material, as illustrated in Figure 6C, or may leave uncovered portions of the connecting bars CB where it is desired to grow further electrically conductive material, as illustrated in Figure 6B (where the second patterned photoresist layer M2' is illustrated with dashed lines).

As mentioned previously, it may be advantageous to grow further electrically conductive material at the trenches T in regions where electrically conductive lines 166 are formed (in a previous electrolytic plating step, for instance); this results in a thicker layer of electrically conductive material grown at the side surfaces of the trenches T that provide the electrically conductive lines 166.

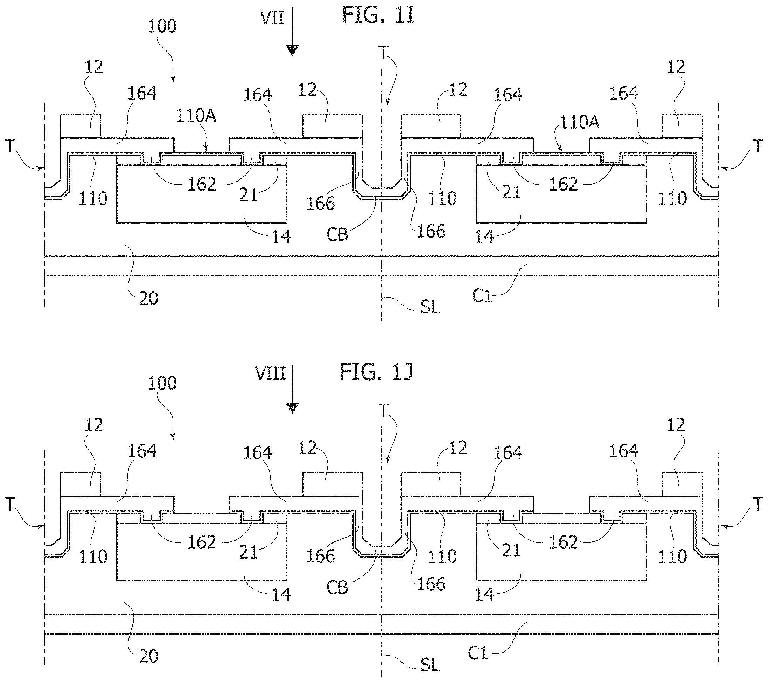

Figures 1I and 1J are illustrative of the panel 100 subsequent to removing first M1' and second M2' patterned photoresist layer (Figure 1I) and subsequent to removing the seed material at regions 110A of the seed layer 110 (Figure 1J).

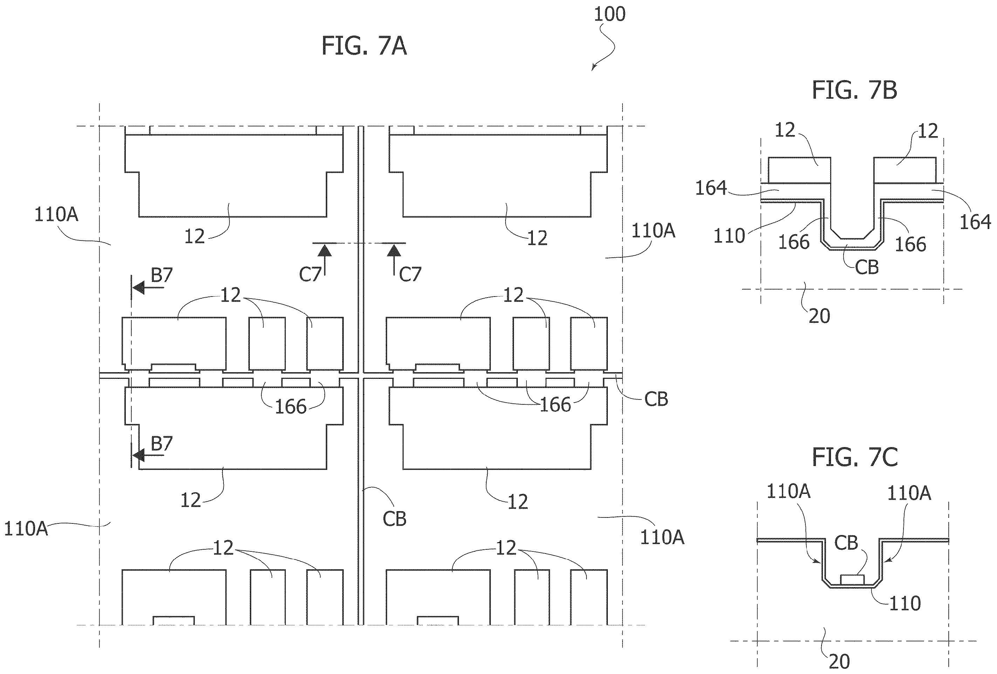

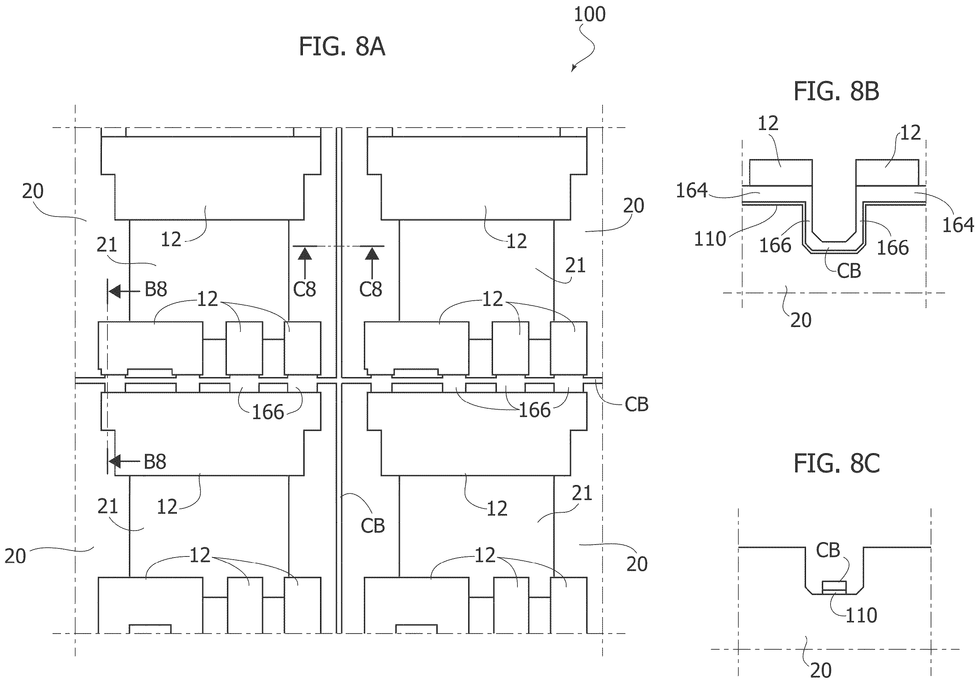

The panel 100 resulting from such processing steps is also visible in the plan views of Figures 7A and 8A, illustrative of a panel 100 as illustrated in Figures 1I and 1J, respectively, seen in the direction of view indicated by the arrows VII and VIII of Figures 1I and 1J, respectively.

Details of such processing steps are illustrated also in the cross-sectional views of Figures 7B, 7C (along lines B7-B7 and C7-C7, respectively, of Figure 7A) and in the cross-sectional views of Figures 8B, 8C (along lines B8-B8 and C8-C8, respectively, of Figure 8A).

As illustrated in Figures 1I and 7A to 7C, first M1' and second M2' patterned photoresist layers are removed (stripped) leaving the portions/regions 110A of the seed layer 110 uncovered. That is, first regions of the seed layer 110 have electrically conductive material grown thereon (vias 162, traces 164, lines 166 and connecting bars CB), with the seed layer 110 comprising second regions 110A adjacent and complementary to the first regions, that are left exposed at the top/front surface of the panel 100 subsequent to removing the first M1' and the second M2' patterned photoresist layers.

With reference to Figure 1J and 8A to 8C, the seed material at the second regions 110A of the seed layer 110 is removed.

Processing as described in the foregoing results in a patterned metallic layer 160, 12, CB formed at the surface of the panel 100 (that is, the top surface of the panel 100 in the figures) by growing electrically conductive material (copper, for instance) at selected regions thereof.

As illustrated, the patterned metallic layer 160, 12, CB comprises:
a redistribution layer 160 (comprising vias 162 and traces 164) common to the plurality of semiconductor dice 14 embedded in the panel 100,
pads 12 grown onto the common redistribution layer 160, wherein the pads 12 are electrically coupled to semiconductor dice 14 in the plurality of semiconductor dice 14 embedded in the panel 100 via the common redistribution layer 160, and
connecting bars CB grown at the trenches T formed in the surface of the panel 100, wherein the connecting bars CB are electrically coupled to the pads 12 via the common redistribution layer 160.

The (electrically conductive) connecting bars CB formed at the trenches T facilitate keeping the patterned metallic layer 160, 12, CB at a (common) electrical potential. As described in the following, this may be advantageous in so far as it facilitates electrolytically plating solder material onto selected regions of the patterned metallic layer 160.

As illustrated, in one or more embodiments the connecting bars CB may be formed by growing electrically conductive material at a bottom surface of the trenches T formed in the surface of the panel 100 (as illustrated in Figures 7B and 7C, for instance). The connecting bars CB may be electrically coupled to the common redistribution layer 160 via electrically conductive lines 166 in the common redistribution layer 160 formed by growing electrically conductive material at side surfaces of the trenches T (as illustrated in Figure 7B, for instance).

In summary, solutions as described in the foregoing comprise encapsulating a plurality of semiconductor dice 14 in an electrically insulating encapsulation (molding material 20 and build-up film 21, for instance) to form a panel 100 having the plurality of semiconductor dice 14 embedded therein.

Subsequently, trenches T are formed in a surface (the top surface on the figures) of the panel 100 having the plurality of semiconductor dice 14 embedded therein. The trenches T are formed at singulation lines SL between adjacent panel portions, each panel portion comprising at least one semiconductor die 14 of the plurality of semiconductor dice 14.

A patterned metallic layer 160, 12, CB is subsequently formed at the surface of the panel 100 by growing (via electroplating, for instance) electrically conductive material at selected regions thereof

The patterned metallic layer 160, 12, CB comprises:
a redistribution layer 160 common to the plurality of semiconductor dice 14 embedded in the panel 100,
pads 12 grown onto the common redistribution layer 160, wherein the pads 12 are electrically coupled to semiconductor dice 14 in the plurality of semiconductor dice 14 embedded in the panel 100 via the common redistribution layer 160, and
connecting bars CB grown at the trenches T formed in the surface of the panel 100, wherein the connecting bars CB are electrically coupled to the pads 12 via the common redistribution layer 160.

It is noted that embodiments of the present description may advantageously be applied also when devices provided with a multilayer redistribution layer (RDL) are desired.

As per se known to those skilled in the art, a multilayer RDL (N layers, for instance) may be formed by providing a plurality of patterned layers of electrically conductive formations.

For each (patterned) layer of electrically conductive formations this may involve:
growing a patterned layer of electrically conductive formations, such as traces and vias, for instance (facilitated by a patterned photoresist layer as discussed in the foregoing, for instance),
laminating an electrically insulating build-up (or mold) film onto the patterned layer of electrically conductive formations to embed the electrically conductive formations in the in the build-up film, and
opening (via laser ablation, for instance) vias through the build-up film towards the electrically conductive formations embedded therein.

Such processing steps, per se conventional in the art, may be repeated for each layer of the N-1 layers of the RDL that is desired to provide.

Processing as described in the foregoing results in a plurality of electrically conductive layers embedded in a plurality of electrically insulating build-up films.

Said otherwise, a panel 100 may be obtained having the plurality of semiconductor dice 14 and electrically conductive formations (the first N-1 layers of the N layers RDL) embedded therein, wherein the panel 100 is formed by encapsulating the plurality of semiconductor dice 14 as well as electrically conductive formations therefor in an electrically insulating encapsulation (comprising the molding material 20, the build-up film at the surface of the die 14 and the build-up films used to encapsulate the formations of the first N-1 layers of the multilayer RDL).

Similarly to what has been described previously, subsequent processing steps may comprise:
forming trenches T in a surface of the panel 100 having the plurality of semiconductor dice 14 as well as electrically conductive formations (the first N-1 layers of the multilayer RDL) therefor embedded therein, wherein the trenches T are formed at singulation lines SL between adjacent panel portions, each panel portion comprising at least one semiconductor die 14 of said plurality of semiconductor dice 14, and
forming a patterned metallic layer (comprising the common redistribution layer 160, the pads 12 and the connecting bars CB) at the surface of the panel 100 by growing electrically conductive material at selected regions thereof.

The common redistribution layer 160 is electrically coupled to the semiconductor dice 14 via the electrically conductive formations embedded in the electrically insulating encapsulation.

Solutions as described herein, may be advantageous in so far as the patterned metallic layer 160, 12, CB may be kept at a common electric potential via the connecting bars CB (electrically coupled to the pads 12 via the common redistribution layer 160), thus facilitating electrolytically growing solder material 130 onto selected regions/portions of the patterned metallic layer 160, 12, CB kept at a plating potential via the connecting bars CB.

As discussed in the foregoing, solutions as described herein may comprise also encapsulating the plurality of semiconductor dice 14 as well as electrically conductive formations therefor (the first N-1 layer of a multilayer RDL of the final device, for instance) in the electrically insulating encapsulation 20, 21 to form a panel 100 having the plurality of semiconductor dice 14 and the electrically conductive formations embedded therein, wherein the electrically conductive redistribution layer 160 common to the plurality of semiconductor dice 14 embedded in the panel 100 is electrically coupled to the plurality of semiconductor dice 14 via said electrically conductive formations embedded in the panel 100.

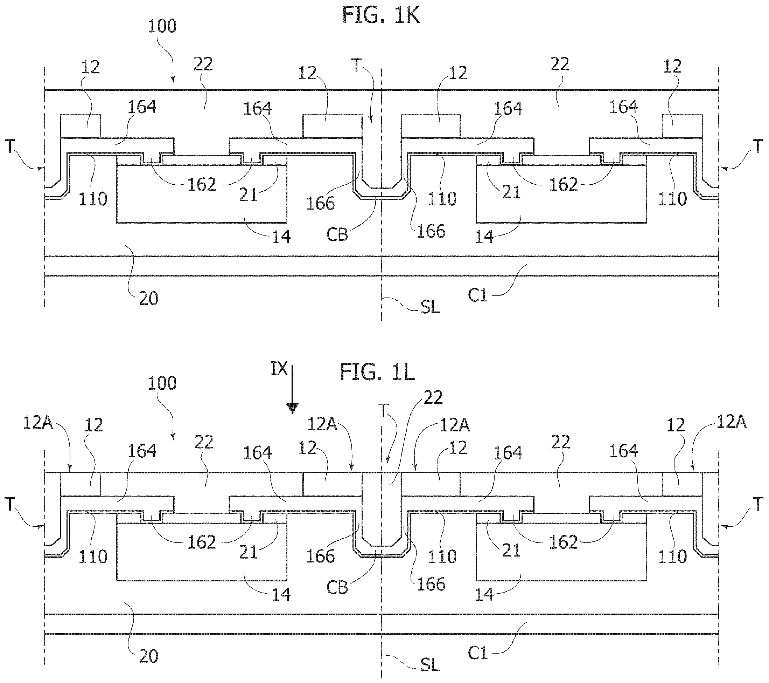

Figure 1K is illustrative of a molding step where further encapsulation material 22 (a molding material such as an epoxy resin, for instance) is molded onto the front/top surface of the panel 100 (having the patterned metallic layer 160, 12, CB formed thereon) to form a further electrically insulating encapsulation 22.

As illustrated, the further encapsulation material 22 covers the whole surface of the panel and, in particular, encapsulates the common redistribution layer 160, the pads 12 and the connecting bars CB, with electrically insulating molding material 22 filling the trenches T.

Figure 1L is illustrative of a panel 100 resulting from partially removing (via grinding, for instance) the (further) encapsulation material 22 to expose a surface 12A of the pads 12 formed onto the common redistribution layer 160. That is, the further encapsulation material 22 is partially removed starting from the top/front surface of the further encapsulation 22 to expose a surface 12A of the pads 12 of solder material.

Said otherwise, Figures 1K and 1L are illustrative of processing steps to encapsulate the patterned metallic layer 160, 12, CB formed at the surface of the panel 100 in a further encapsulation 22 of electrically insulating material, wherein the further encapsulation 22 has a surface opposite the surface of the panel 100, and wherein electrically conductive material 12A of the pads 12 is exposed at the (top/front) surface of the further encapsulation 22.

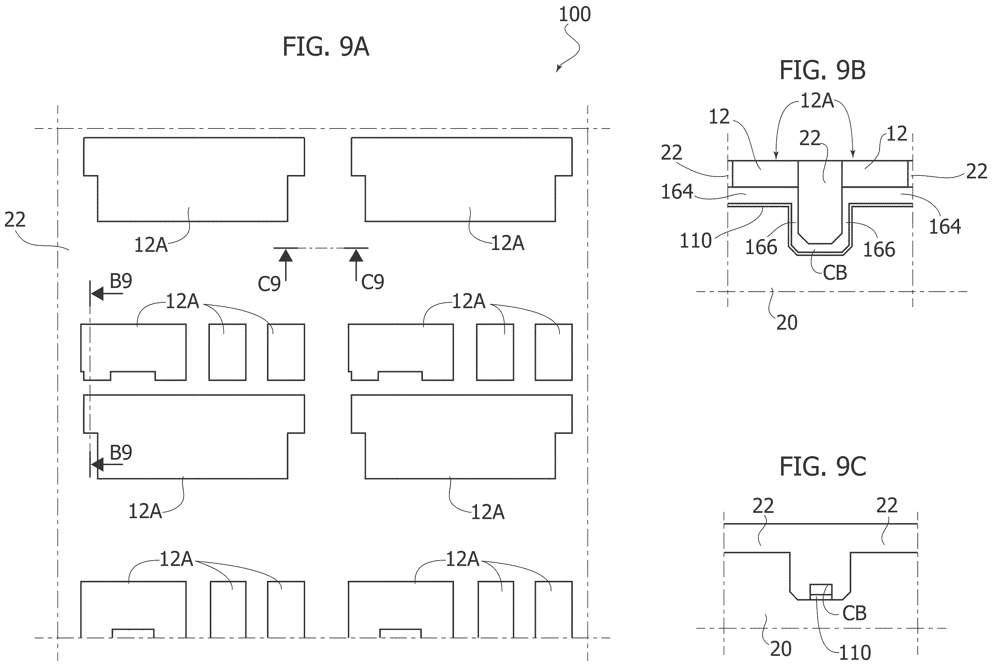

A panel 100 resulting from processing steps as described with reference to Figures 1K and 1L is illustrated also in Figures 9A to 9C, wherein:

Figure 9A is a plan view of a panel as illustrated in Figure 1L seen in the direction of view indicated by the arrow IX, and

Figures 9B and 9C are cross-sectional views along lines 9B-9B and 9C-9C, respectively, of Figure 9A.

As illustrated in Figure 9A, a further encapsulation 22 of electrically insulating material encapsulates the patterned metallic layer, that is, the common redistribution layer 160, the connecting bars CB and (partially) the pads 12. The pads 12 have electrically conductive material (that is, the top/front surface 12A of the pads 12) exposed at the top/front surface of the further encapsulation 22.

Figure 1M is a cross-sectional view illustrative of a processing step where electrically insulating material of the further encapsulation 22 provided (via molding) at the trenches T is removed.

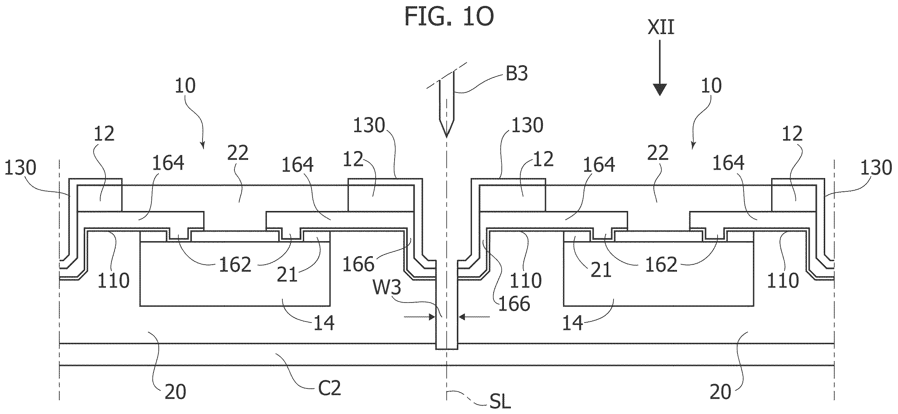

As illustrated, the panel 100 may be removed from the first carrier C1 and arranged on a second temporary (and possibly sacrificial) carrier C2. The second carrier C2 may be a dicing tape, for instance, in order to facilitate further processing steps (for instance, the singulation step discussed with reference to Figure 1O).

As illustrated in Figure 1M, removing the electrically insulating molding compound 22 at the trenches T results in electrically conductive material of the lines 166 grown at the side surfaces of the trenches exposed at the surface of the panel 100.

It is noted that electrically conductive material of the connecting bars CB grown at the bottom surface of the trenches T may also be exposed in response to the electrically insulating material 22 being removed from the trenches T.

In one or more embodiments, the electrically insulating material 22 filling the trenches T may be removed via laser ablation.

In one or more embodiments, the electrically insulating material 22 filling the trenches T may be removed by performing a partial cut via a saw or blade B2, as illustrated in Figure 1M. In these embodiments, a second blade B2 is used, the second blade B2 having a second blade width W2 smaller than the blade width W1 of the first blade B1, that is W2<W1.

The second blade may have a second blade width W2 of 350 microns, for instance.

The person skilled in the art may appreciate that, as mentioned previously, it may be advantageous to grow a relatively thick layer of electrically conductive material at the trenches T in regions where electrically conductive lines 166 are formed in so far as the electrically conductive material of the lines 166 at the side surfaces of the trenches T may be partially removed during a processing step as described with reference to Figure 1M; a thicker layer of electrically conductive material makes the "partial cut" that is performed to expose the electrically conductive material of the lines 166 and of the connecting bars CB less critical in terms of width and/or alignment of the blade B2 (or the laser source) with respect to the panel 100.

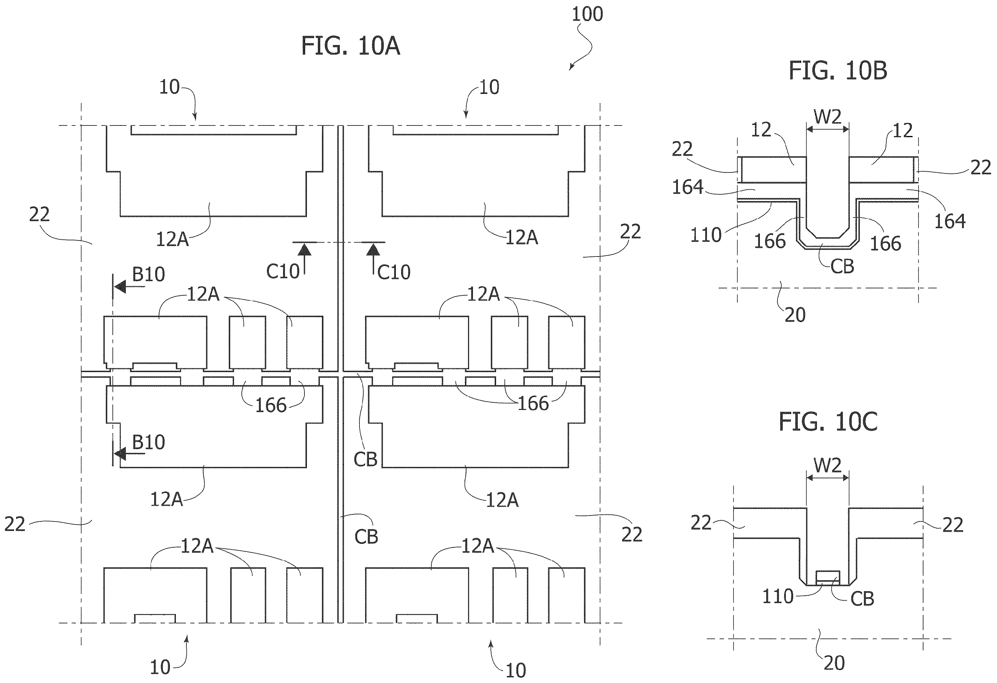

A panel 100 resulting from processing steps as described with reference to Figure 1M is illustrated also in Figures 10A to 10C, wherein:

Figure 10A is a plan view of a panel 100 as illustrated in Figure 1M seen in the direction of view indicated by the arrow X, and

Figures 10B and 10C are cross-sectional views along lines 10B-10B and 10C-10C, respectively, of Figure 10A.

With reference to Figure 10A, the electrically insulating material 22 is removed from the trenches T thus exposing electrically conductive material of the connecting bars CB.

As illustrated also in Figures 10B and 10C, such a processing step may result in exposing (that is, leaving uncovered from the molding material 22) the electrically conductive material of the connecting bars CB grown at a bottom surface of the trenches T and the electrically conductive material of the electrically conductive lines 166 grown at side surfaces of the trenches T.

As illustrated in Figures 10A to 10C, electrically conductive material exposed at the top/front surface of the panel 100 may comprise:
electrically conductive material of the pads 12 (at the surface 12A thereof) exposed in response to encapsulation material 22 removed (via grinding, for instance) from the top/front surface of the panel 100 (as described with reference to Figure 1L),
electrically conductive material of the connecting bars CB grown at the bottom surface of the trenches T, exposed in response to encapsulation material 22 filling the trenches T being removed (via a partial cut, for instance, as described with reference to Figure 1M), and
electrically conductive material of the electrically conductive lines 166 grown at the side surfaces of the trenches T, exposed in response to encapsulation material 22 filling the trenches T being removed (via a partial cut, for instance, as described with reference to Figure 1M).

Figure 1N is illustrative of solder material 130 (tin or a tin alloy, for instance) grown onto the electrically conductive material of the patterned metallic layer 160, 12, CB exposed (left uncovered by the electrically insulating encapsulation material 22, for instance) at the top/front surface of the panel 100.

Suitable solder materials 130 comprise, in general, materials having a relatively high wettability on materials used in semiconductor manufacturing (for instance, materials used for pads finishing). Wettability may be measured, for instance, by measuring the contact angle (a lower contact angle corresponding to a higher wettability); suitable solder materials may be characterized by a relatively low contact angle (as low as 10/15 degrees, for instance), or a contact angle lower than oxidized copper or "clean" copper, for instance.

According to embodiments of the present description, an electrolytic plating step is advantageously used to grow solder (and electrically conductive) material 130 onto the electrically conductive material of the patterned metallic layer 160, 12, CB exposed at the surface of the panel 100.

As those skilled in the art may appreciate, the electrolytic growth/deposition of solder material 130 is facilitated by the connecting bars CB that facilitate keeping the common redistribution layer 160 and the pads 12 onto which solder material is grown at a common electric potential; an electric field can thus be established that forces ions of the solder material in the plating bath to deposit onto the electrically conductive material of the common redistribution layer 160 and the pads 12.

As illustrated, solder material 130 may be plated also at the (exposed) surface of the connecting bars CB formed at the trenches T.

The thickness of the layer of solder material 130 that can be grown via electrolytic plating is considerably larger than the thickness of a layer of solder material that may be plated via electroless plating; layer of solder material 130 having a thickness in the range between 5 and 40 microns may be grown, for instance.

As discussed previously, electrolytic plating of solder material 130 may be advantageous with respect to electroless plating in so far as electroless deposition of a solder material such as tin results in (fairly) thinner layers of tin, having a thickness of about 3 to 5 microns, for instance.

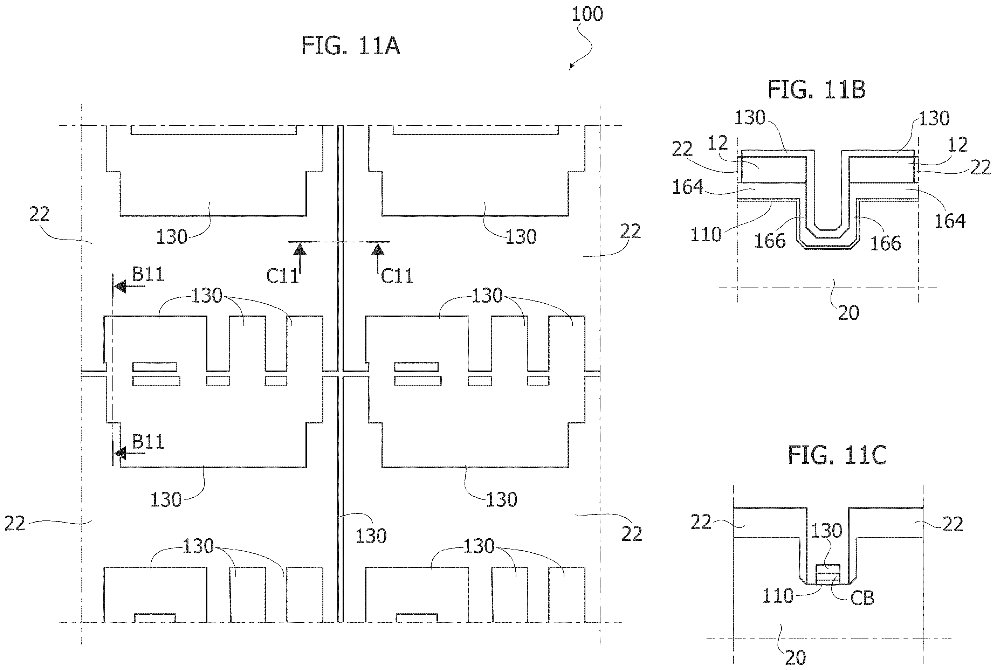

A panel 100 resulting from processing steps as described in the foregoing is illustrated also in Figures 11A to 11C, wherein:

Figure 11A is a plan view of a panel as illustrated in Figure 1N seen in the direction of view indicated by the arrow XI, and

Figures 11B and 11C are cross-sectional views along lines 11B-11B and 11C-11C, respectively, of Figure 11A.

As illustrated, a layer of solder material 130 is grown onto the exposed electrically conductive material of the patterned metallic layer 160, 12, CB.

Growing the layer of solder material 130 comprises:
keeping the patterned metallic layer 160, 12, CB at a plating (electric) potential via the connecting bars CB, and
electrolytically growing solder material 130 onto the exposed electrically conductive material of the patterned metallic layer 160, 12, CB kept at a plating (electric) potential via the connecting bars CB.

Advantageously, the panel 100 having the layer of solder material 130 grown at the front/top surface thereof is processed via a baking step to facilitate forming an intermetallic region at the interface between the electrically conductive material (copper, for instance) of the patterned metallic layer 160, 12, CB and the solder material (tin, for instance) of the layer of solder material 130.

For instance, in one or more embodiments the patterned metallic layer 160, 12, CB may be formed by growing copper material and the layer of solder material 130 may be formed by growing (via electroplating) tin material. In such embodiments, baking the panel 100 at a temperature of about 150°C for one hour has been observed to give satisfactory results in terms of formation of an intermetallic region at the interface between the copper material of the patterned metallic layer 160, 12, CB and the tin material of the layer of solder material 130.

As illustrated in Figure 1O, the panel 100 is singulated/partitioned into a plurality of (individual) panel portions wherein each panel portion provides a (finished) semiconductor device 10.

Singulating the panel 100 may be done via sawing, for instance, at singulation lines SL. As illustrated in Figure 1O, the singulation step may be performed with a third blade B3, having a third blade width W3 that is smaller than the second blade width W2 of the second blade B2.

As illustrated, the connecting bars CB are removed in the singulation step.

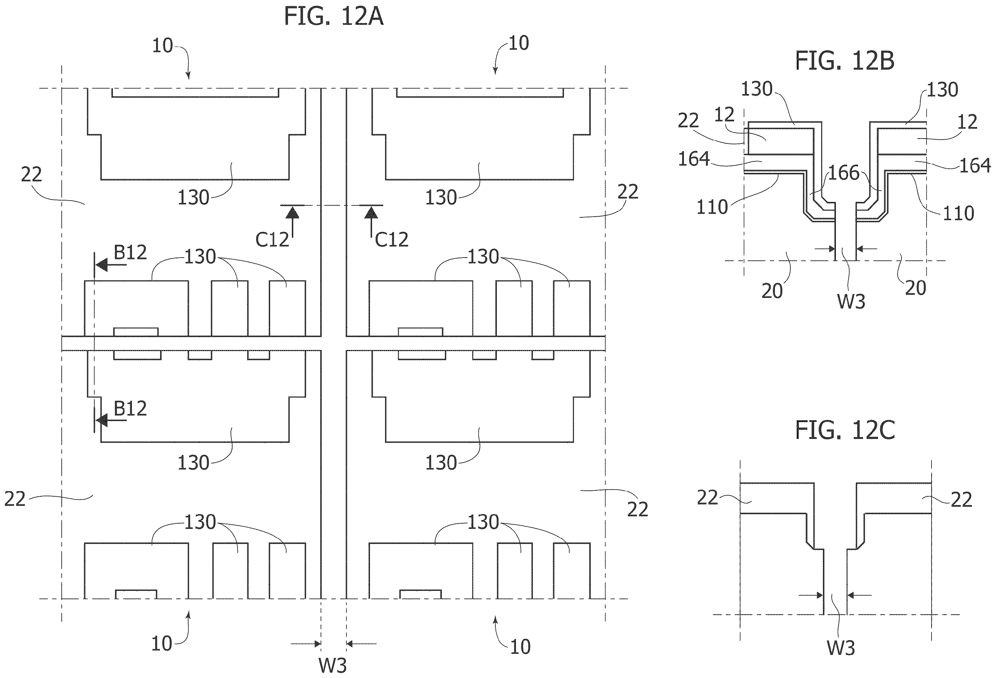

The assembly resulting from a singulation step as described in the forgoing is also illustrated in Figures 12A to 12C, wherein:

Figure 12A is a plan view of a panel as illustrated in Figure 1O seen in the direction of view indicated by the arrow XII, and

Figures 12B and 12C are cross-sectional views along lines 12B-12B and 12C-12C, respectively, of Figure 12A.

As illustrated in Figure 12A, the panel 100 is partitioned into a plurality of panel portions, wherein each (singulated) panel portion provides a (finished) semiconductor device 10.

Each semiconductor device 10 comprises a layer of solder material 130 (electrolytically) grown onto the electrically conductive material exposed at the surface of the portion of the panel 10.

Said otherwise, embodiments of the present description may involve singulating the panel 100, wherein the connecting bars CB formed at the trenches T are removed in response to the singulation step.

The panel 100 is partitioned into a plurality of panel portions 10, each comprising:
at least one semiconductor die 14 embedded in a portion of the panel 100 of electrically insulating encapsulation material 20, 21, 22,
a portion of the common redistribution layer 160,
pads 12 grown onto the portion of the common redistribution layer 160, wherein the pads 12 are electrically coupled to the at least one semiconductor die 14 via the portion of the common redistribution layer 160, and
a layer of solder material 130 grown onto the exposed electrically conductive material of the pads 12 grown onto the portion 16 of the common redistribution layer 160.

As illustrated in Figure 12B, the singulation step may result in the connecting bars CB formed at the bottom surface of the trenches being removed with the electrically conductive lines 166 left at the side of the (singulated) devices 10, with a layer of solder material 130 grown onto the electrically conductive material of the electrically conductive lines 166.

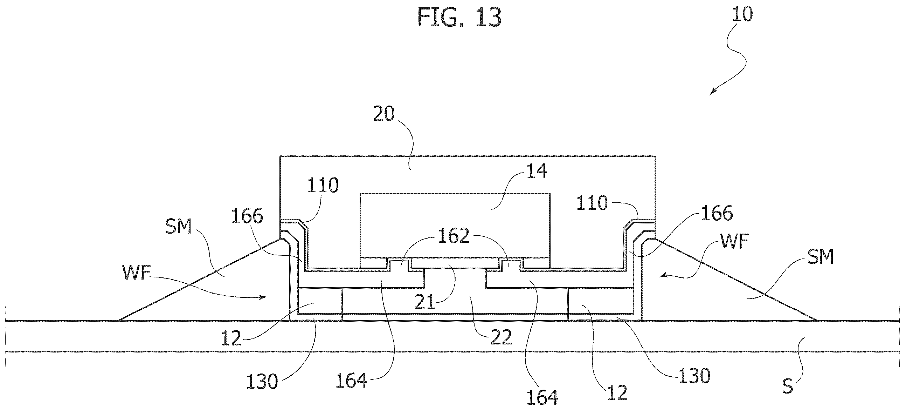

Figure 13 is a cross-sectional view illustrative of a semiconductor device 10 obtainable via processing steps as described in the foregoing. The device 10 exemplified in Figure 13 is mounted onto a final supporting substrate S (a PCB, for instance).

As illustrated, mounting the semiconductor device 10 may be facilitated by (further) solder material SM provided at the pads 12 to facilitate forming the electrical coupling between the pads 12 and the supporting substrate S.

The semiconductor device 10 may have solder material 130 (electrolytically) grown onto the electrically conductive material at the sides of the device 10 (that is, grown onto the lines 166). That is, the semiconductor device 10 is provided with wettable flanks WF that facilitate forming a solder fillet SM.

As illustrated, a relatively high fillet (wherein the height of the fillet depends on the depth of the trenches T formed in the panel 100) is formed at the wettable flanks WK. Such a high fillet SM improves reliability of the joint and facilitates optical inspection (via automatic optical inspection, AOI, for instance) of the joints between the semiconductor device 10 and the supporting substrate S.

The device thus comprises:
at least one semiconductor die 14 embedded in an electrically insulating encapsulation 20, 21,
a redistribution layer 160 (a portion of the common redistribution layer 160),
pads (or studs) 12 grown onto said redistribution layer 160, wherein the pads 12 are electrically coupled to the at least one semiconductor die 14 via the redistribution layer 160,
a further encapsulation 22 of electrically insulating encapsulation material encapsulating the redistribution layer 160as well as the pads 12 grown thereon, wherein the further encapsulation 22 has a surface opposite said surface of the encapsulation 20, 21, and wherein electrically conductive material 12A of the pads 12 is exposed at the surface of the further encapsulation 22, and
a layer of solder material 130 electrolytically grown onto the exposed electrically conductive material of the pads 12 grown onto the redistribution layer 160.

As illustrated, the redistribution layer 160 may comprise electrically conductive lines 166 grown at side surfaces of the electrically insulating encapsulation 20.

The further encapsulation 22 encapsulating the redistribution layer 160 as well as the pads 12 grown thereon leaves exposed electrically conductive material of said electrically conductive lines 166 grown at the side surfaces of the electrically insulating encapsulation 20, and the device comprises a layer of solder material 130 electrolytically grown onto the exposed electrically conductive material of the electrically conductive lines 166.

In summary, in solutions as described with reference to the figures, a plurality of semiconductor dice 14 is encapsulated in an electrically insulating encapsulation 20, 21 to form a panel 100 having the plurality of semiconductor dice 14 embedded therein.

Trenches T are formed in a surface of the panel 100 having the plurality of semiconductor dice 14 embedded therein, wherein the trenches T are formed at singulation lines SL between adjacent panel portions, each panel portion comprising at least one semiconductor die 14 of said plurality of semiconductor dice 14.

A patterned metallic layer 160, 12, CB is formed at the surface of the panel 100 by growing electrically conductive material at selected regions thereof.

The patterned metallic layer 160, 12, CB comprises:
a redistribution layer 160 common to the plurality of semiconductor dice 14 embedded in the panel 100,
pads 12 grown onto the common redistribution layer 160, wherein the pads 12 are electrically coupled to semiconductor dice 14 in the plurality of semiconductor dice 14 embedded in the panel 100 via the common redistribution layer 160, and
connecting bars CB grown at said trenches T formed in the surface of the panel 100, wherein the connecting bars CB are electrically coupled to the pads 12 via the common redistribution layer 160.

The connecting bars CB may be formed by growing electrically conductive material at a bottom surface of the trenches T formed in the surface of the panel 100, wherein the connecting bars CB are electrically coupled to the common redistribution layer 160 via electrically conductive lines 166 in the common redistribution layer 160 formed by growing electrically conductive material at side surfaces of said trenches T.

The patterned metallic layer 160, 12, CB may be encapsulated in a further encapsulation 22 of electrically insulating encapsulation material, wherein the further encapsulation 22 has a surface opposite said surface of the panel 100, and wherein electrically conductive material 12A of said pads 12 is exposed at said surface of the encapsulation 22.

The further encapsulation 22 may comprise electrically insulating encapsulation material that fills the trenches T formed in the surface of the panel 100. The electrically insulating encapsulation material that fills the trenches T may be removed to expose electrically conductive material of the connecting bars CB.

In one or more embodiments, removing electrically insulating encapsulation material that fills the trenches T comprises:
exposing electrically conductive material of the connecting bars CB grown at a bottom surface of the trenches T, and
exposing electrically conductive material of the electrically conductive lines 166 grown at side surfaces of the trenches T.

Subsequently, a layer of solder material 130 may be grown onto the exposed electrically conductive material of the patterned metallic layer 160, 12, CB. Growing said layer of solder material 130 comprises:
keeping the patterned metallic layer 160, 12, CB at a plating potential via said connecting bars CB, and
electrolytically growing solder material 130 onto the exposed electrically conductive material of the patterned metallic layer 160, 12, CB kept at a plating potential via said connecting bars CB.

The panel 100 may be singulated at the singulation lines SL between adjacent panel portions, wherein the connecting bars CB formed at the trenches Tare removed in response to said singulating, and wherein the panel 100 is partitioned into a plurality of panel portions 10, each comprising:
at least one semiconductor die 14 embedded in a portion of the panel 100,
a portion of the common redistribution layer 160,
pads 12 grown onto said portion of the common redistribution layer 160, wherein the pads 12 are electrically coupled to the at least one semiconductor die 14 via said portion of the common redistribution layer 160, and
a layer of solder material 130 grown onto the exposed electrically conductive material of the pads 12 grown onto the portion 16 of the common redistribution layer 160.

Singulating the panel 100 at the singulation lines SL comprises removing the connecting bars CB formed at the bottom surface of the trenches T leaving the electrically conductive lines 166 at side surfaces of the panel portions 10, and wherein each panel portion 10 the panel 100 is singulated into comprises a layer of solder material 130 grown onto the exposed electrically conductive material of said electrically conductive lines 166.

Without prejudice to the underlying principles, the details and the embodiments may vary, even significantly, with respect to what has been described by way of example only without departing from the scope of the embodiments.

The extent of protection is determined by the annexed claims.

## Claims

1. A method, comprising:
encapsulating a plurality of semiconductor dice (14) in an electrically insulating encapsulation (20, 21) to form a panel (100) having the plurality of semiconductor dice (14) embedded therein,
forming trenches (T) in a surface of the panel (100) having the plurality of semiconductor dice (14) embedded therein, wherein the trenches (T) are formed at singulation lines (SL) between adjacent panel portions, each panel portion comprising at least one semiconductor die (14) of said plurality of semiconductor dice (14), and
forming a patterned metallic layer (160, 12, CB) at the surface of the panel (100) by growing electrically conductive material at selected regions thereof, wherein the patterned metallic layer (160, 12, CB) comprises:
a redistribution layer (160) common to the plurality of semiconductor dice (14) embedded in the panel (100),
pads (12) grown onto the common redistribution layer (160), wherein the pads (12) are electrically coupled to semiconductor dice (14) in the plurality of semiconductor dice (14) embedded in the panel (100) via the common redistribution layer (160), and
connecting bars (CB) grown at said trenches (T) formed in the surface of the panel (100), wherein the connecting bars (CB) are electrically coupled to the pads (12) via the common redistribution layer (160).

2. The method of claim 1, wherein the connecting bars (CB) are formed by growing electrically conductive material at a bottom surface of the trenches (T) formed in the surface of the panel (100), and wherein the connecting bars (CB) are electrically coupled to the common redistribution layer (160) via electrically conductive lines (166) in the common redistribution layer (160) formed by growing electrically conductive material at side surfaces of said trenches (T).

3. The method of claim 1 or claim 2, wherein forming the patterned metallic layer (160, 12, CB) at the surface of the panel (100) comprises:
forming a seed layer (110) of seed material at said surface of the panel (100) having the trenches (T) formed therein,
growing electrically conductive material onto first regions of said seed layer (110) to form said patterned metallic layer (160, 12, CB), wherein the seed layer (110) comprises second regions (110A) adjacent and complementary to said first regions of the seed layer (110) having electrically conductive material grown thereon, and
removing the seed material at said second regions (110A) of the seed layer (110).

4. The method of claim 3, comprising growing electrically conductive material, preferably copper, onto said first regions of said seed layer (110) to form said patterned metallic layer (160, 12, CB) via electroplating.

5. The method of any of the previous claims, comprising encapsulating the patterned metallic layer (160, 12, CB) in a further encapsulation (22) of electrically insulating encapsulation material, wherein the further encapsulation (22) has a surface opposite said surface of the panel (100), and wherein electrically conductive material (12A) of said pads (12) is exposed at said surface of the encapsulation (22).

6. The method of claim 5, wherein said further encapsulation (22) comprises electrically insulating encapsulation material that fills the trenches (T) formed in the surface of the panel (100), and the method comprises removing electrically insulating encapsulation material that fills the trenches (T) to expose electrically conductive material of the connecting bars (CB).

7. The method of claim 6, wherein said trenches (T) are formed via a first saw (B1) having a first width W1, preferably 400 microns, and the method comprises removing electrically insulating encapsulation material that fills the trenches (T) via a second saw having a second width W2, preferably 350 microns, wherein said second width W2 is less than said first width W1, W2<W1.

8. The method of claim 6 or claim 7, in so far as depending on claim 2, wherein said removing electrically insulating encapsulation material that fills the trenches (T) comprises:
exposing electrically conductive material of the connecting bars (CB) grown at a bottom surface of the trenches (T), and
exposing electrically conductive material of the electrically conductive lines (166) grown at side surfaces of the trenches (T).

9. The method of any of claims 5 to 8, comprising growing a layer of solder material (130) onto the exposed electrically conductive material of the patterned metallic layer (160, 12, CB), wherein growing said layer of solder material (130) comprises:
keeping the patterned metallic layer (160, 12, CB) at a plating potential via said connecting bars (CB), and
electrolytically growing solder material (130) onto the exposed electrically conductive material of the patterned metallic layer (160, 12, CB) kept at a plating potential via said connecting bars (CB).

10. The method of claim 9, comprising growing said layer of solder material (130) with a layer thickness in a range between 5 to 40 microns.

11. The method of claim 9 or claim 10, comprising singulating the panel (100) at said singulation lines (SL) between adjacent panel portions, wherein the connecting bars (CB) formed at the trenches (T) are removed in response to said singulating, and wherein the panel (100) is partitioned into a plurality of panel portions (10), each comprising:
at least one semiconductor die (14) embedded in a portion of the panel (100),
a portion of the common redistribution layer (160),
pads (12) grown onto said portion of the common redistribution layer (160), wherein the pads (12) are electrically coupled to the at least one semiconductor die (14) via said portion of the common redistribution layer (160), and
a layer of solder material (130) grown onto the exposed electrically conductive material of the pads (12) grown onto the portion (16) of the common redistribution layer (160).

12. The method of claim 11 in so far as dependent of claim 7, wherein singulating the panel (100) at said singulation lines (SL) comprises removing the connecting bars (CB) formed at the bottom surface of the trenches (T) leaving the electrically conductive lines (166) at side surfaces of the panel portions (10), and wherein each panel portion (10) the panel (100) is singulated into comprises a layer of solder material (130) grown onto the exposed electrically conductive material of said electrically conductive lines (166).

13. A semiconductor product, comprising:
a panel (100) of electrically insulating encapsulation material (20, 21) having a plurality of semiconductor dice (14) embedded therein, the panel (100) having trenches (T) formed in a surface thereof at singulation lines (SL) between adjacent panel portions, each panel portion comprising at least one semiconductor die (14) of said plurality of semiconductor dice (14), and
a patterned metallic layer (160, 12, CB) formed at the surface of the panel (100) by growing electrically conductive material at selected regions thereof,
wherein the patterned metallic layer (160, 12, CB) comprises:
a redistribution layer (160) common to the plurality of semiconductor dice (14) embedded in the panel (100),
pads (12) grown onto the common redistribution layer (160), wherein the pads (12) are electrically coupled to semiconductor dice (14) in the plurality of semiconductor dice (14) via the common redistribution layer (160), and
connecting bars (CB) grown at said trenches (T) formed in the surface of the panel (100), wherein the connecting bars (CB) are electrically coupled to the pads (12) via the common redistribution layer (160).

14. The semiconductor product of claim 13, comprising connecting bars (CB) formed by growing electrically conductive material at a bottom surface of the trenches (T) formed in the surface of the panel (100), and wherein the connecting bars (CB) are electrically coupled to the common redistribution layer (160) via electrically conductive lines (166) in the common redistribution layer (160) formed by growing electrically conductive material at side surfaces of said trenches (T).

15. The semiconductor product of claim 13 or claim 14, comprising a further encapsulation (22) of electrically insulating encapsulation material encapsulating the patterned metallic layer (160), wherein the encapsulation (22) has a surface opposite said surface of the panel (100), and wherein electrically conductive material (12A) of said pads (12) in the patterned metallic layer (160) is exposed at said surface of the encapsulation (22).

16. The semiconductor product of claim 15 and claim 14, wherein the further encapsulation (22) encapsulating the patterned metallic layer (160, 12, CB) leaves exposed:
electrically conductive material of the connecting bars (CB) grown at a bottom surface of the trenches (T), and
electrically conductive material of the electrically conductive lines (166) grown at side surfaces of said trenches (T).

17. The semiconductor product of claim 15 or claim 16, comprising a layer of solder material (130) electrolytically grown onto the exposed electrically conductive material of the patterned metallic layer (160, 12, CB).

18. A device, comprising:
at least one semiconductor die (14) embedded in an electrically insulating encapsulation (20),
a redistribution layer (160),
pads (12) grown onto said redistribution layer (160), wherein the pads (12) are electrically coupled to the at least one semiconductor die (14) via the redistribution layer (160),
a further encapsulation (22) of electrically insulating encapsulation material encapsulating the redistribution layer (160) as well as the pads (12) grown thereon, wherein the further encapsulation (22) has a surface opposite said surface of the encapsulation (20, 21), and wherein electrically conductive material (12A) of said pads (12) is exposed at said surface of the further encapsulation (22), and
a layer of solder material (130) electrolytically grown onto the exposed electrically conductive material of the pads (12) grown onto the redistribution layer (160),
wherein the redistribution layer (160) comprises electrically conductive lines (166) grown at side surfaces of the electrically insulating encapsulation (20), wherein the further encapsulation (22) encapsulating the redistribution layer (160) as well as the pads (12) grown thereon leaves exposed electrically conductive material of said electrically conductive lines (166) grown at the side surfaces of the electrically insulating encapsulation (20), and wherein the device comprises a layer of solder material (130) electrolytically grown onto the exposed electrically conductive material of said electrically conductive lines (166).
